**Europäisches Patentamt**

**European Patent Office**

**Office européen des brevets**

(19)

(11) Veröffentlichungsnummer : **0 444 096 B1**

(12)

# EUROPÄISCHE PATENTSCHRIFT

(45) Veröffentlichungstag der Patentschrift :
**28.10.92 Patentblatt 92/44**

(51) Int. Cl.⁵ : **A61H 39/02,** G01R 33/28,
G01R 33/48

(21) Anmeldenummer : **89912985.2**

(22) Anmeldetag : **21.11.89**

(86) Internationale Anmeldenummer :
**PCT/AT89/00106**

(87) Internationale Veröffentlichungsnummer :
**WO 90/05519 31.05.90 Gazette 90/12**

(54) **SYSTEM ZUR BESTIMMUNG DER LAGE VON REZEPTORENBEREICHEN.**

(30) Priorität : **21.11.88 AT 2845/88**

(43) Veröffentlichungstag der Anmeldung :
**04.09.91 Patentblatt 91/36**

(45) Bekanntmachung des Hinweises auf die
Patenterteilung :
**28.10.92 Patentblatt 92/44**

(84) Benannte Vertragsstaaten :
**AT DE FR GB IT NL SE**

(56) Entgegenhaltungen :
**EP-A- 0 197 791**
**EP-A- 0 228 692**
**DE-A- 2 854 774**
**DE-A- 2 928 826**
**DE-A- 3 500 118**

(56) Entgegenhaltungen :
**DE-B- 2 551 226**
**BIOMEDIZINISCHE TECHNIK, volume 32, Nr.
11, November 1987 (Berlin,DE) U. Stilla et al.:
Berechnung elektrischer Felder inbiologischen Geweben auf der Basis von Klassifizierten NMR-Bilddaten" pages 288-292, see the
whole article**

(73) Patentinhaber : **SZELES, Josef Constantin
Glanzinggasse 5/7
A-1190 Wien (AT)**

(72) Erfinder : **SZELES, Josef Constantin
Glanzinggasse 5/7
A-1190 Wien (AT)**

(74) Vertreter : **Weinzinger, Arnulf, Dipl.-Ing. et al
Patentanwälte Sonn, Pawloy, Weinzinger &
Wolfram Riemergasse 14
A-1010 Wien (AT)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf einen Apparat zur Bestimmung der Lage von Rezeptorenbereichen mit einer physikalische Eigenschaften des Gewebes im Bereich der Rezeptorenbereiche meßtechnisch erfassenden Vorrichtung.

Es besteht ein reizleitender Zusammenhang zwischen einzelnen Körperteilen und Rezeptorenbereichen, welche an anderen Stellen des Körpers unter der Hautoberfläche liegen. Es kann durch Stimulation von Rezeptorenbereichen Einfluß auf die diesen Rezeptorenbereichen zugeordneten Körperteile ausgeübt werden. Dieser Zusammenhang wird bei der Akupunktur dazu ausgenützt, durch Stimulation von unter der Hautoberfläche liegenden Punkten bzw. Bereichen auf an anderen Stellen des Körpers liegende Körperteile Einfluß zu nehmen. Man kann dabei zur Stimulation solcher Punkte bzw. Bereiche Nadeln in die Oberfläche des Körpers einstechen. Die Rezeptorenbereiche sind nun verhältnismäßig klein, in der Regel kleiner als 1 mm, und es ist für eine wirkungsvolle Beeinflussung der einem Rezeptorenbereich zugeordneten Körperteile erforderlich, daß die Stimulation genau an der Stelle des betreffenden Rezeptorenbereiches vorgenommen wird.

Man kann durch eine Stimulation von Rezeptorenbereichen Störungen, die an bestimmten Körperteilen vorliegen oder von solchen Störungen hervorgerufene Schmerzzustände im Sinne einer Normalisierung bzw. Besserung beeinflussen.

Es treten beim Vorliegen von Veränderungen bzw. aus solchen Veränderungen resultierenden Schmerzempfindungen auch an den Rezeptorenbereichen, welche den betroffenen Körperteilen zugeordnet sind, Veränderungen der Nervenaktivitäten auf, welche den Zustand des Gewebes im Gebiet der Rezeptorenbereiche verändern; es kommt meist zu Veränderungen der Flüssigkeitsverteilung (Flüssigkeitsverschiebung) in diesen Gewebebereichen. Es können aber in den Rezeptorenbereichen, auch ohne daß die zugeordneten Körperteile Veränderungen zeigen, Abweichungen gegenüber dem umgebenden Gewebe vorliegen, aus denen die Lage der Rezeptorenbereiche erkennbar ist. Es ist dabei auch möglich, durch Einflußnahme auf die den Rezeptorenbereichen zugeordneten Körperteile die Erkennbarkeit der Rezeptorenbereiche zu verbessern.

Bei einem bekannten Apparat eingangs erwähnter Art hat man versucht die Lage von zur Akupunktur zu benützenden Rezeptorenbereiche dadurch zu ermitteln, daß man mittels auf die Haut aufgelegter Elektroden und mittels eines an diese angeschalteten Spannungsmeßgerätes die Membranpotentiale in dem in Frage kommenden Bezirk der Haut meßtechnisch ermittelt und aus der gemessenen Potentialverschiebung auf die Lage der betreffenden Bereiche schließt. Es ist auch bekannt anstelle solcher Potentialmessungen oder ergänzend zu diesen in ähnlicher Weise den elektrischen Widerstand im Bereich der Haut zu messen und aus den dabei erhaltenen Meßwerten auf die Lage von zur Akupunktur zu benützenden Punkten zu schließen und auch gegebenenfalls sowohl bei den Potentialmessungen als auch bei den Widerstandsmessungen Hilfsspannungen oder Hilfsströme, die mit zusätzlichen Elektroden oder mit den Meßelektroden selbst zugeführt werden, in Anwendung zu bringen. Die Zuverlässigkeit dieser bekannten Techniken ist nicht zufriedenstellend, vor allem weil die Haut in ihrer äußeren Schicht in unregelmäßiger Weise verhornt ist und dies die elektrischen Messungen beeinträchtigt; es liegen aber auch von vornherein stark unterschiedliche Gewebseigenschaften in jenen Gebieten vor, in denen sich Rezeptorenbereiche befinden, und es können diese Unterschiede, welche den zu ermittelnden Veränderungen überlagert sind, bei den bekannten Systemen praktisch nicht befriedigend ausgegrenzt werden, selbst wenn man zur Verwendung von durch die Hautoberfläche eingestochenen Elektroden übergeht, was nicht nur durch die in der Regel größere Zahl notwendiger Meßpunkte unangenehm empfunden wird, sondern durch die unangenehmen Empfindungen zu Veränderungen führen kann, die die Messungen nachteilig beeinflussen.

Eine Messung des elektrischen Potentials oder der Magnetfeldstärke, die an einzelnen Stellen eines Hautbezirkes vorliegen, zur Bestimmung der Lage von zur Akupunktur zu benützenden Punkten ist auch in der DE-A-2 928 826 beschrieben. Es werden dabei zur Messung Sonden benützt, welche die Felder in einem sehr kleinen Bereich erfassen, und es werden diese Sonden bei der Messung über den zu untersuchenden Hautbezirk geführt.

Es ist ein Ziel der vorliegenden Erfindung einen Apparat eingangs erwähnter Art zu schaffen, mit dem die genaue Lage von Rezeptorenbereichen in einer die betreffende Person möglichst wenig belastenden Weise rasch ermittelt werden kann; insbesondere soll dabei die genaue Lage von Rezeptorenbereichen bestimmbar sein, in deren unmittelbarer Umgebung dadurch, daß an den diesen Rezeptorenbereichen zugeordneten Körperteilen Veränderungen vorliegen, Veränderungen im Gewebe, vor allem Veränderungen der Flüssigkeitsverteilung (Flüssigkeitsverschiebung), aufgetreten sind.

Der erfindungsgemäße Apparat eingangs erwähnter Art ist dadurch gekennzeichnet, daß die die physikalischen Eigenschaften des Gewebes erfassende Vorrichtung ein Kernspintomograph ist, und daß der Apparat weiter eine Anzeigeeinrichtung für die direkt über den Rezeptorenbereichen gelegenen Hautstellen, in Form einer mit der Abbildungseinheit des Kernspintomographen verbundenen Markiereinrichtung, mit der eine Markierung auf eine über dem Meßgebiet liegende Hautstelle setzbar ist; oder in Form mindestens eines an einem mit Positionsgebern versehenen Manipulator angeordneten Indikatorkörpers aufweist. Es kann durch diesen Apparat der vorstehend angeführten Zielsetzung gut entsprochen und auf eine für die betreffende Person kaum belastende Weise eine genaue Bestimmung der Lage von Rezeptorenbereichen erzielt werden. Es können dabei die über den Rezeptorenbereichen gelegenen Hautstellen genau bezeichnet werden, so daß gewährleistet ist, daß bei einer von den mit dem erfindungsgemäßen Apparat angezeigten Hautstellen ausgehenden Stimulation, z.B. mit zur Stimulation eingestochenen Nadeln, die Rezeptorenbereiche getroffen werden; ganz allgemein kann die bestehende Zuordnung zwischen Körperteilen und Rezeptorenbereichen exakt lokalisiert werden. Kernspintomographen werden häufig auch MRI-Geräte (magnetic resonance imaging) genannt.

Es kann erwähnt werden, daß es aus der EP-A-0 228 692 bekannt ist, bei der diagnostischen Untersuchung des Körpers mit einem Kernspintomatographen zur Feststellung von an inneren Organen vorliegenden Schäden, Indikatorkörper, die bei der Kernspintomographie mit abgebildet werden, an der Hautoberfläche anzuordnen, um einen hinweis auf die Lage der Organe bzw. Schädigungen im Körper zu erhalten.

Eine bevorzugte Ausführungsform des erfindungsgemäßen Apparates ist dadurch gekennzeichnet, daß der Kernspintomograph zur Erfassung der Verteilung von Wasserstoffatomen bzw. Protonen im Gewebe ausgebildet ist. Diese Ausbildung ermöglicht eine besonders vorteilhafte Erfassung der im Gewebe jeweils vorliegenden Flüssigkeitsverschiebung und ist weiter auch hinsichtlich der bei der Kernspintomographie erzielbaren Empfindlichkeit vorteilhaft. Es ist weiter günstig wenn der Kernspintomograph eine Low Field-Kernspintomograph ist, weil damit dem möglichen Auftreten von, vom Magnetfeld des Tomographen her verursachten Veränderungen des Gewebszustandes im Bereich der Rezeptorenbereiche weitestgehend entgegengewirkt ist.

Hinsichtlich des Erzielens eines möglichst einfachen Aufbaues des Kernspintomographen und hinsichtlich einer möglichst einfachen Erfassung der in ihrer ungefähren Lage bereits bekannten Bereiche des abzubildenden Gewebes, sowie auch hinsichtlich des Erzielens einer gut erkennbaren Abbildung kleinräumiger Gewebsveränderungen, welche in der Regel in der unmittelbaren Umgebung der jeweils interessierenden Rezeptorenbereiche vorliegen, ist eine Ausführungsform des erfindungsgemäßen Apparates vorteilhaft, welche dadurch gekennzeichnet ist, daß mindestens die Empfangsspule des Kernspintomographen bzw. eine Sende- und Empfangsspule desselben und gegebenenfalls auch eine Sendespule des Kernspintomographen als bewegliche(s) Element(e) ausgebildet ist bzw. Sind, das (die) unmittelbar am Meßgebiet, z.B. am Ohr oder an einer Stelle des Rumpfes, placierbar ist (sind).

Wenn man beim erfindungsgemäßen Apparat einen Indikatorkörper vorsieht, soll dieser im allgemeinen nichtmagnetisch, d.h. auch nicht magnetisierbar, sein, damit auf ihn durch das für die Kernspintomographie erforderliche Magnetfeld keine verschiebend wirkenden Kräfte einwirken, und damit das für die Kernspintomographie erforderliche Magnetfeld keine Verzerrung erfährt. Es ist aber auch möglich, einen solchen Indikatorkörper durch spezielle Materialwahl und Formgebung dahingehend auszubilden, daß in seiner unmittelbaren Nähe eine besondere Verzerrung des Magnetfeldes entsteht, welche eine für die Lagebestimmung von Rezeptorenbereichen besonders günstige Form der Abbildungsflächen, welche z.B. statt eben auch gekrümmt sein können, erzielen läßt. Die Lage des Indikatorkörpers kann einfach dadurch mit der kernspintomographischen Abbildung des Gewebes in Beziehung gesetzt werden, daß der Indikatorkörper selbst kernspintomographisch abgebildet wird, und damit zusammen mit der kernspintomographischen Abbildung der Umgebung der Rezeptorenbereiche auf der Abbildungseinheit des Kernspintomographen sichtbar ist; indem der Indikatorkörper mit dem mit Positionsgebern versehenen Manipulator über die Hautoberfläche im Bereich der Rezeptorenbereiche bewegt wird, deren genaue Lage ermittelt werden soll, kann die Abbildung der Rezeptorenbereiche mit der Abbildung des Indikatorkörpers zur Deckung gebracht werden, wonach sich der Indikatorkörper über dem betreffenden Rezeptorenbereich befindet. Damit ist die Lage dieses Rezeptorenbereiches festgelegt. Man kann für eine beabsichtigte spätere Stimulierung, um die durch die Lage des Indikatorkörpers angegebene Lage des Rezeptorenbereiches zu kennzeichnen, an der betreffenden Stelle der Haut eine Markierung, z.B. mit einer geeigneten Farbe, anbringen.

Eine Variante der vorgenannten Ausführungsform ist dadurch gekennzeichnet, daß die Positionsgeber des Manipulators , an dem der Indikatorkörper angeordnet ist, zur Abbildung der jeweils vorliegenden Lage des Indikatorkörpers an der Abbildungseinheit des Kernspintomographen mit dieser Abbildungseinheit oder mit Einstellern in der Steuer- und Recheneinheit des Kernspintomographen, die ihrerseits mit der Abbildungseinheit gekoppelt sind, verbunden sind. Diese Variante ermöglicht von der Handhabung des Apparates her gesehen eine einfachere und raschere Ermittlung der Lage der Rezeptorenbereiche, weil der Indikatorkörper unter Beobachtung einer in der Abbildungseinheit des Kernspintomographen sichtbaren Marke, welche die jeweils vorliegende Lage des Indikatorkörpers angibt, mit der Abbildung eines Rezeptorenbereiches zur Deckung gebracht werden kann, wobei der Indikatorkörper mit dem Manipulator an die über dem Rezeptorenbereich liegende Hautstelle gesetzt wird, und die jeweils vorliegende Lage des Indikatorkörpers durch die Positionsgeber des Manipulators mit der auf der Abbildungseinheit sichtbaren Marke koordiniert ist.

Ist anstelle eines Indikatorkörpers eine Markiereinrichtung vorgesehen, kann man die in der Abbildungseinheit des Kernspintomographen erkennbare Lage des betreffenden Rezeptorenbereiches unmittelbar durch eine mit dieser Markiereinrichtung hergestellte Markierung an der über dem betreffenden Rezeptorenbereich liegenden Hautstelle sichtbar machen; die Markierung kann dabei z.B. eine Lichmarke oder eine Farbstoffmarke sein. Man kann auch in diesem Fall, ähnlich wie dies vorstehend im Zusammenhang mit einem Indikatorkörper erörtert worden ist, die Markierung, welche z.B. eine Erwärmung eines kleinen Hautbezirkes bewirkt, durch kernspintomographische Abbildung zusammen mit der Umgebung des Rezeptorenbereiches auf der Abbildungseinheit des Kernspintomographen zur Darstellung bringen; durch entsprechendes Verstellen der Markiereinrichtung kann die Abbildung der Markierung mit der Abbildung des Rezeptorenbereiches zur Deckung gebracht werden und so die Lage des Rezeptorenbereiches an der über diesem Rezeptorenbereich liegenden Hautstelle bezeichnet werden. Eine einfachere Handhabung und eine schnellere Festlegung der Lage des betreffenden Rezeptorenbereiches ist mit einer Ausführungsform des erfindungsgemäßen Apparates möglich, welche dadurch gekennzeichnet ist, daß mindestens eine, an dem über dem Meßgebiet liegenden Hautbezirk optische Markierungen bildende Markiereinrichtung vorgesehen ist, die mit einem Positionsgeber aufweisenden Manipulator versehen oder an einem solchen Manipulator angeordnet ist, wobei diese Positionsgeber zur Abbildung der jeweils vorliegenden Stellung der Markiereinrichtung an der Abbildungseinheit des Kernspintomographen mit dieser Abbildungseinheit oder mit Einstellern in der Steuer- und Recheneinheit des Kernspintomographen, die ihrerseits mit der Abbildungseinheit gekoppelt sind, verbunden sind. Es braucht auch bei dieser Ausführungsform durch entsprechendes Verstellen des Manipulators nur die der jeweiligen Stellung der Markiereinrichtung entsprechende Marke in der Abbildungseinheit des Kernspintomographen mit einer dort befindlichen Abbildung eines Rezeptorenbereiches zur Deckung gebracht werden um die Markiereinrichtung auf eine über einem Rezeptorenbereich liegende Hautstelle auszurichten.

Eine sehr einfache Ausführungsform ist dadurch gekennzeichnet, daß die Markiereinrichtung ein Lichtzeiger ist. Es kann bei dieser Ausbildungsform des Apparates so gearbeitet werden, daß zunächst eine kernspintomographische Abbildung des relevanten Rezeptorenbereiches auf der Abbildungseinheit des Kernspintomographen gebildet wird, daß danach die Meßeinrichtung des Kernspintomographen abgeschaltet wird und allenfalls Geräteteile des Kernspintomographen, welche den untersuchten Körperteil verdecken, wie z.B. Sendespulen oder Empfangsspulen, entfernt werden, und daß dann unter Benützung der genannten Abbildung die Markiereinrichtung in einen die über dem betreffenden Rezeptorenbereich liegende Hautstelle anzeigenden Zustand gebracht wird. Die so erhaltene Lichtmarkierung kann ganz allgemein zur Festlegung von Zuordnungen zwischen Körperteilen und Rezeptorenbereichen oder gewünschtenfalls zur genauen Lokalisierung von Stimulationsstellen verwendet werden. Hinsichtlich einer exakten Anzeige der Lage der Rezeptorenbereiche und hinsichtlich eines einfachen Aufbaues der Lichtstrahlführung ist es dabei von Vorteil, wenn der Lichtzeiger ein Laserzeiger ist.

Soll die Markierung auch außerhalb des Apparates, mit dem sie gebildet worden ist, für einige Zeit sichtbar sein, z.B. für den Fall, daß eine Auswertung oder Stimulation erst einige Zeit nach der Lagebestimmung der Rezeptorenbereiche durchgefüdrt werden soll, ist eine Ausführungsform dieses Apparates vorteilhaft, welche dadurch gekennzeichnet ist, daß die Markiereinrichtung eine Farbauftragseinrichtung, vorzugsweise eine Farbpunktauftragseinrichtung ist. Die Farbauftragseinrichtung kann dabei z.B. eine Farbtröpfchenschleudereinrichtung sein, bei der durch elektrische Betätigung Farbtröpfchen aus einer Kapillare auf die zu markierende Stelle geschleudert werden.

Die Erfindung wird nun anhand von Beispielen, welche in der Zeichnung schematisch dargestellt sind, weiter erläutert.

Die Darstellungen in der Zeichnung sind rein schematisch gehalten, und es sind dabei vor allem die Größenverhältnisse der einzelnen dargestellten Elemente nur im Sinne einer möglichst leichten Erkennbarkeit der Zusammenhänge, ohne Berücksichtigung der tatsächlich vorliegenden Abmessungen gewählt worden. In der Zeichnung zeigt: Fig. 1 eine erste Ausführungsform eines erfindungsgemäß ausgebildeten Apparates, Fig. 2 eine andere Ausführungsform eines solchen Apparates, mit einer als Laserzeiger ausgebildeten Markiereinrichtung, Fig. 3 eine weitere Ausführungsform eines derartigen Apparates, mit einem an einem Manipulator angeordneten Indikatorkörper, Fig. 4 eine Ausführungsform eines erfindungsgemäßen Apparates, bei dem Sendespule und Empfangsspule des Kernspintomographen als bewegliche Elemente ausgebildet sind, und Fig. 5 ein Apparat mit einer als Farbpunktauftragseinrichtung ausgebildeten Markiereinrichtung.

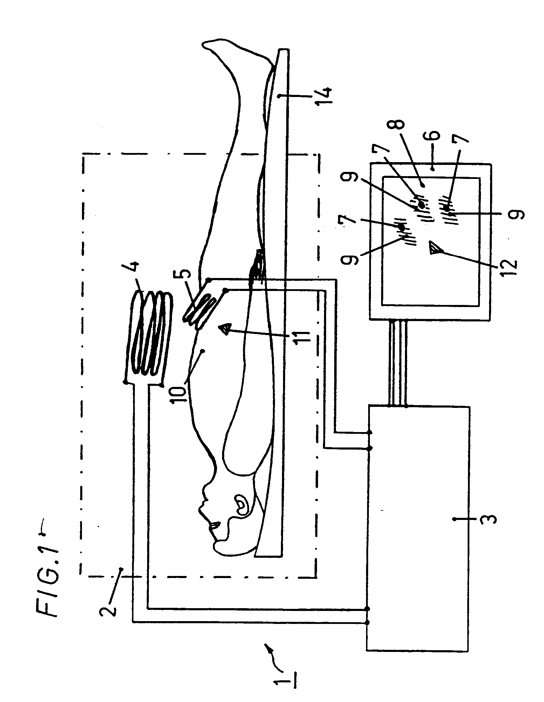

Bei der in Fig. 1 dargestellten Ausführungsform eines Apparates zur Bestimmung der Lage von Rezeptorenbereichen, ist ein Kernspintomograph 1 vorgesehen, der eine nicht näher dargestellte Magneteinheit aufweist, mit der ein Magnetfeld 2 erzeugt wird, welches den Untersuchungsraum erfüllt und schematisch durch ein strichpunktiertes Rechteck angedeutet ist. Der Kernspintomograph 1 ist mit einer Steuer- und Recheneinheit 3 ausgestattet, an welche die Sendespule 4 und die Empfangsspule 5 angeschlossen sind. Weiter ist an die Steuer- und Recheneinheit 3 die Abbildungseinheit 6 des Kernspintomographen angeschlossen. Es wird mit dieser Abbildungseinheit eine Abbildung von unter der Hautoberfläche liegenden Gebieten, in denen Rezeptorenbereiche 7 liegen oder vermutet werden, hergestellt; durch die oben erwähnten Abweichungen, die in der unmittelbaren Umgebung der Rezeptorenbereiche 7 im Vergleich zu dem danebenliegenden Gewebe 8 vorliegen, nämlich vor allem Veränderungen der Flüssigkeitsverteilung (Flüssigkeitsverschiebung) hebt sich die unmittelbare Umgebung 9 der Rezeptorenbereiche 7 in der Abbildung von der Abbildung des umliegenden Gewebes 8 ab, und es können so die Rezeptorenbereiche 7 erkannt werden. Zur Anzeige der unmittelbar über den Rezeptorenbereichen liegenden Hautstellen am Körper 10 der mit dem Kernspintomographen untersuchten Person, ist ein Indikatorkörper 11 vorgesehen, der über die Hautoberfläche bewegt werden kann; der Indikatorkörper 11 kann seinerseits in Form einer Marke 12 an der Abbildungseinheit 6 abgebildet werden, und unter Beobachtung bzw. Zuhilfenahme dieser Marke 12 über die Oberfläche des Körpers 10 bewegt werden, bis er sich unmittelbar bei einem Rezeptorenbereich 7 befindet. Die untersuchte Person ruht dabei auf einer Abstützung 14, z.B. auf einem Liegetisch, welche unerwünschte Bewegungen, die die-Genauigkeit der Lagebestimmung beeinträchtigen könnten, weitgehend ausschaltet. In der Regel ist es günstig eine größere Sendespule und eine im Vergleich dazu kleinere Empfangsspule vorzusehen; die Empfangsspule 5 wird zweckmäßig als bewegliches Element ausgebildet, welches in unmittelbarer Nähe der zu erfassenden bzw. abzubildenden Bereiche angeordnet und mit einer geeigneten Halterung dort stabil gehalten werden kann; die Empfangsspule wird vorteilhaft als Oberflächenspule ausgebildet; es ist zweckmäßig, durch entsprechende Steuerung in der Steuer- und Recheneinheit, die Empfangsspule nach Abschalten der zuvor eingeschalteten Sendespule einzuschalten. Es ist auch möglich eine kombinierte Sende- und Empfangsspule vorzusehen, die wie an sich bekannt in geeigneter Weise von der Steuer- und-Recheneinheit gesteuert wird. Es kann im Hinblick auf die damit erzielbare extrem feine Auflösung der Abbildung und im Hinblick auf die erzielbare hohe Empfindlichkeit ein für hohe Magnetfeldstärke (0,5 T bis 2,5 T) ausgebildeter Kernspintomograph im Apparat vorgesehen werden. Vielfach ist es aber auch günstig mit niedriger Magnetfeldstärke (Low Field-Kernspintomograph) zu arbeiten, um möglichst wenig Magneteinfluß auf die an sich sensiblen Vorgänge in der Umgebung der Rezeptorenbereiche auszuüben.

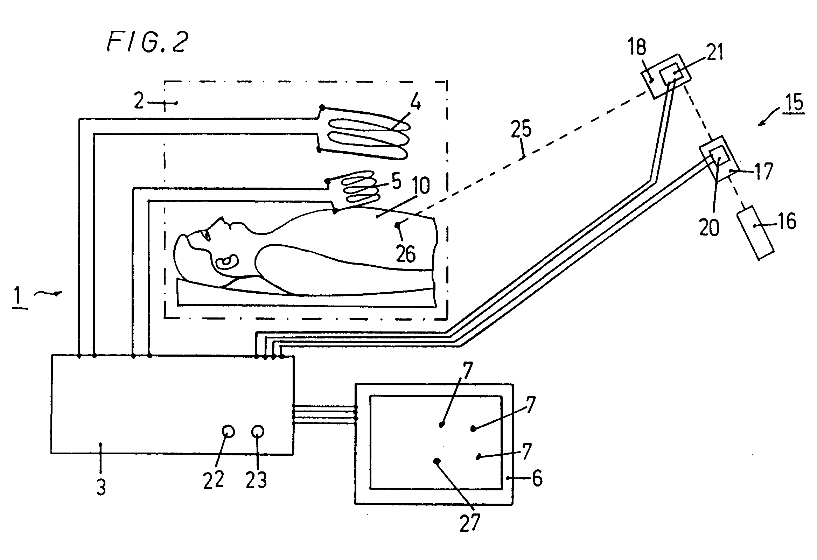

Bei der in Fig. 2 dargestellten Ausführungsform eines erfindungsgemäßen Apparates ist zur Anzeige der unmittelbar über Rezeptorenbereichen liegenden Hautstellen eine optische Markiereinrichtung in Form eines Laserzeigers vorgesehen. Dieser Laserzeiger 15 weist eine Laserlichtquelle 16 und zwei Laserstrahl-Ablenkeinheiten 17, 18 auf, in denen aktive Positionsgeber 20, 21 angeordnet sind, welche an die Steuer- und Recheneinheit 3 des Kernspintomographen angeschlossen sind. Die Positionsgeber 20, 21 sind mit Einstellorganen 22, 23, die an der Steuer- und Recheneinheit 3 vorgesehen sind, steuerbar, und es ist damit durch die Laserstrahl-Ablenkeinheiten 17, 18 der auf das untersuchte Gebiet weisende Laserstrahl 25 bewegbar, wobei gleichzeitig über die Verbindung der Steuer- und Recheneinheit 3 mit der Abbildungseinheit 6 eine dem Auftreffpunkt 26 des Laserstrahls 25 auf einer im Untersuchungsgebiet liegenden Hautstelle entsprechende Marke 27 an der Abbildungseinheit 6 zur Darstellung kommt. Durch Bedienung der Einstellorgane 22, 23 kann der Laserstrahl 25 bzw. der Auftreffpunkt 26 und gleichlaufend die Marke 27 koordinatenmäßig verstellt werden, bis sich die Marke 27 mit einem abgebildeten Rezeptorenbereich 7 deckt, und es zeigt dann der Auftreffpunkt 26 des Laserstrahls 25 die unmittelbar über dem Rezeptorenbereich liegende Hautstelle an.

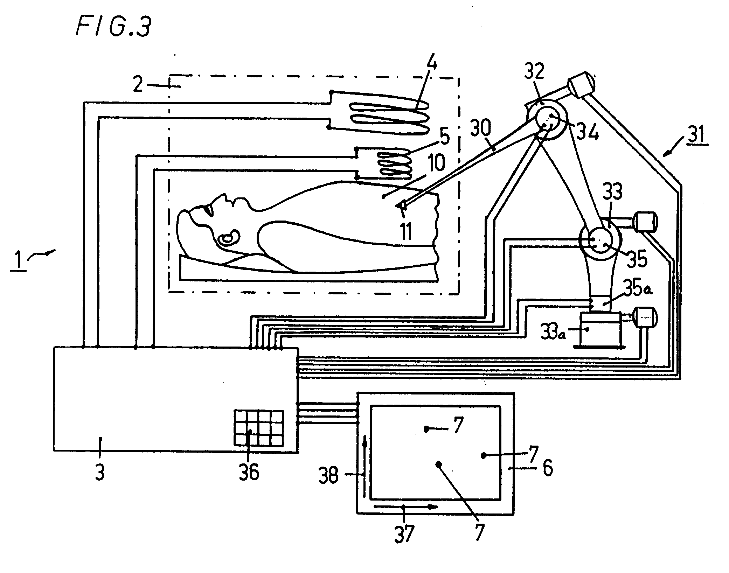

Bei der in Fig. 3 dargestellten Ausführungsform eines erfindungsgemäßen Apparates ist zur Anzeige der im Untersuchungsbereich bzw. Meßbereich über den auf der Abbildungseinheit abgebildeten Rezeptorenbereichen 7 liegenden Hautstellen, ähnlich wie bei der Ausführungsform nach Fig. 1, ein Indikatorkörper 11 vorgesehen. Dieser Indikatorkörper 11 ist am Arm 30 eines Servomanipulators 31 angebracht, der mit Schwenkeinheiten 32, 33, 33a ausgestattet ist, welche von der Steuer- und Recheneinheit 3 her gesteuert werden. In den Schwenkeinheiten 32, 33, 33a sind passive Positionsgeber 34, 35, 35a angeordnet, welche gleichfalls mit der Steuer- und Recheneinheit 3 des Kernspintomographen verbunden sind und Signale abgeben, aus denen sich die jeweils vorliegende Lage des Indikatorkörpers 11 ergibt. Der Servomanipulator 31 ist mit einer Eingabeeinheit 36 steuerbar, wobei die Position, welche der Indikatorkörper 11 einnehmen soll, koordinatenmäßig eingestellt werden kann. Es können so nach Erhalt der Abbildung des die interessierenden Rezeptorenbereiche 7 enthaltenden Körpergebietes auf der Abbildungseinheit 6 die Spulen des Tomographen abgeschaltet und gegebenenfalls vom Untersuchungs- bzw. Meßbereich entfernt werden, und gegebenenfalls kann auch das Magnetfeld abgeschaltet werden, wonach entsprechend den Koordinaten 37, 38, an denen die Abbildungen der Rezeptorenbereiche 7 liegen, der Indikatorkörper 11 mittels der Eingabeeinheit 36 an eine unmittelbar über einem solchen Rezeptorenbereich liegende Hautstelle bewegt werden kann.

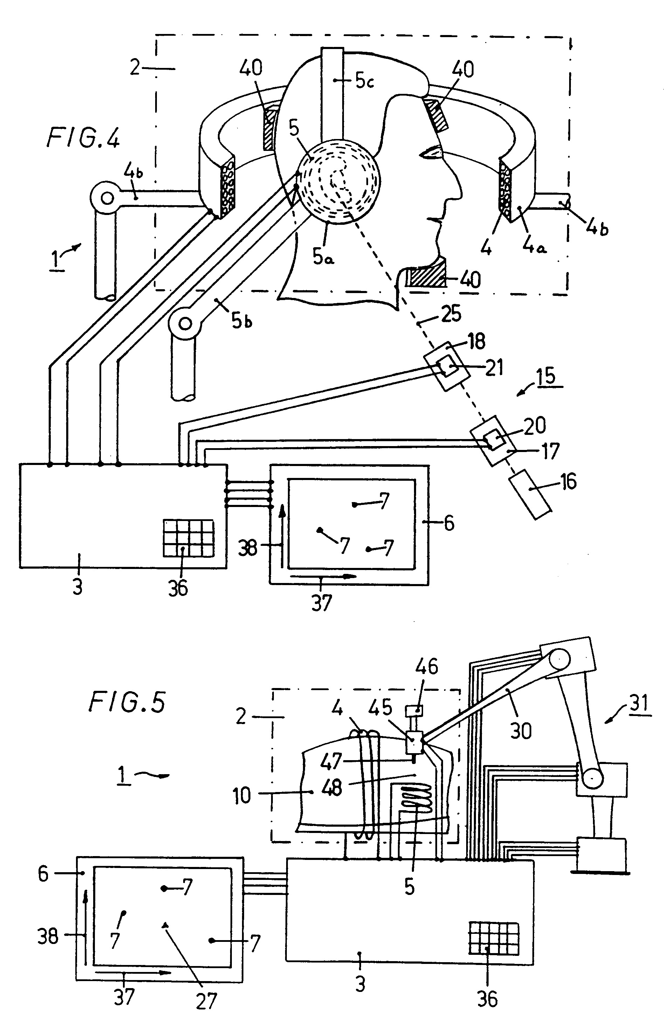

Bei der in Fig. 4 dargestellten Ausführungsform eines erfindungsgemäßen Apparates sind sowohl die Sendespule 4 als auch die Empfangsspule 5 als bewegliche Elemente ausgebildet und auf geeigneten fixierbaren Trägern 4a, 5a angeordnet. Der Träger 4a ist in Form eines am Gestell des Kernspintomographen über Stützarme 4b befestigbaren Ringes ausgebildet, und es hat der Träger 5a die Form einer Schale, welche an einem Tragarm 5b, der zum Gestell des Kernspintomographen führt, sitzt und die an den zu untersuchenden Bereich des Körpers anlegbar ist. Für den zu untersuchenden Körperteil, im dargestellten Fall den Kopf, sind lagesichernde Abstützungen 40 vorgesehen. Zur Positionierung des Spulenträgers 5a mit der Empfangsspule 5 kann gegebenenfalls auch ein in Art eines Kopfhörerbügels ausgebildeter Hilfsträger 5c vorgesehen werden. Die Empfangsspule 5 wird vorteilhaft als Oberflächenspule ausgebildet. Es ist weiter günstig, durch entsprechende Steuerung in der Steuer- und Recheneinheit 3, die Empfangsspule 5 nach Abschalten der zuvor eingeschalteten Sendespule 4 einzuschalten. Die in Fig. 4 dargestellte Ausführungsform eines erfindungsgemäßen Apparates eignet sich besonders zur Bestimmung der Lage von Rezeptorenbereichen, die sich am Kopf, insbesondere am Ohr, befinden. Es ist bei diesem Apparat zur Anzeige der direkt über den Rezeptorenbereichen gelegenen Hautstellen wieder eine optische Markiereinrichtung in Form eines Lichtzeigers, insbesondere Laserzeigers vorgesehen, mit dem die betreffenden Hautstellen nach Abschalten und Abnehmen der Sendespule und der Empfangsspule angezeigt werden können. Man kann dabei einen Laserzeiger 15 vorsehen, wie er bei der Ausführung nach Fig. 2 vorgesehen ist, oder auch andere Ausführungsformen derartiger Laserzeiger. Dargestellt ist ein Laserzeiger, der einen ähnlichen Aufbau, wie der in Fig. 2 dargestellte hat, und der mit einer Eingabeeinheit 36 entsprechend den Koordinaten 37, 38, den die Abbildungen der Rezeptorenbereiche 7 auf der Abbildungseinheit 6 aufweisen, koordinatenmäßig einstellbar ist um die über den Rezeptorenbereichen liegenden Hautstelle anzuzeigen.

Bei der in Fig. 5 dargestellten Ausführungsform ist zur Kenntlichmachung der direkt über den ermittelten Rezeptorenbereichen gelegenen Hautstellen eine Markiereinrichtung in Form einer Farbpunktauftragseinrichtung 45 vorgesehen, mit der elektrisch gesteuert winzige Tröpfchen einer in einem Behälter 46 befindlichen Markierflüssigkeit auf eine vor der Düse 47 dieser Farbpunktauftragseinrichtung befindliche Hautstelle 48 aufgetragen können. Die Farbpunktauftragseinrichtung 45 sitzt an einem Schwenkarm 30 eines Servomanipulators 31, welcher einen ähnlichen Aufbau wie der bei der Ausführungsform nach Fig. 3 vorgesehene Servomanipulator hat. Es kann dabei eine Koordinatensteuerung des Servomanipulators mit einer Eingabeeinheit 36, ähnlich wie bei der Ausführungsform nach Fig. 3, oder auch eine analoge Steuerung mit Einstellorganen vorgesehen werden. Bei der Analogsteuerung wird über die Positionsgeber des Servomanipulators eine Marke auf der Abbildungseinheit des Kernspintomographen erzeugt, deren Lage der momentanen Lage der Farbpunktauftragseinrichtung entspricht, und es wird unter Beobachtung dieser Marke 27 die Farbpunktauftragseinrichtung an die direkt über den Rezeptorenbereichen gelegenen Hautstellen gelenkt und dann das Markieren dieser Hautstellen ausgelöst.

## Patentansprüche

1. Apparat zur Bestimmung der Lage von Rezeptorenbereichen (7) mit einer physikalische Eigenschaften des Gewebes (8) im Bereich der Rezeptorenbereiche meßtechnisch erfassenden Vorrichtung, dadurch gekennzeichnet, daß die die physikalischen Eigenschaften des Gewebes erfassende Vorrichtung ein Kernspintomograph (1) ist, und daß der Apparat weiter eine Anzeigeeinrichtung (15; 45; 11, 31, 6) für die direkt über den Rezeptorenbereichen (7) gelegenen Hautstellen (48), in Form einer mit der Abbildungseinheit (6) des Kernspintomographen (1) verbundenen Markiereinrichtung (15; 45), mit der eine Markierung (26) auf eine über dem Meßgebiet liegende Hautstelle (48) setzbar ist, oder in Form mindestens eines an einem mit Positionsgebern (34, 35, 35a) versehenen Manipulator (31) angeordneten Indikatorkörpers (11) aufweist.

2. Apparat nach Anspruch 1, dadurch gekennzeichnet, daß der Kernspintomograph (1) zur Erfassung der Verteilung von Wasserstoffatomen bzw. Protonen im Gewebe ausgebildet ist.

3. Apparat nach Anspruch 1 oder 2, dadurch gekennzeichnet, daß der Kernspintomograph (1) ein Low Field-Kernspintomograph ist.

4. Apparat nach einem der Ansprüche 1 bis 3, dadurch gekennzeichnet, daß mindestens die Empfangsspule (5) des Kernspintomographen (1) bzw. eine Sende- und Empfangespule desselben und gegebenenfalls auch eine Sendespule (5) des Kernspintomographen als bewegliche Elemente ausgebildet ist bzw. sind, die unmittelbar am Meßgebiet, z.B. am Ohr oder an einer Stelle des Rumpfes, placierbar sind.

5. Apparat nach einem der Ansprüche 1 bis 4, dadurch gekennzeichnet, daß die Positionsgeber (34, 35, 35a) des Manipulators (31), an dem der Indikatorkörper (11) angeordnet ist, zur Abbildung der jeweils vorliegenden Lage des Indikatorkörpers (11) an der Abbildungseinheit (6) des Kernspintomographen (1) mit dieser Abbildungseinheit (6) oder mit Einstellern (36) in der Steuer- und Recheneinheit (3) des Kernspintomographen (1), die ihrerseits mit der Abbildungseinheit (6) gekoppelt sind, verbunden sind.

6. Apparat nach einem der Ansprüche 1 bis 4, dadurch gekennzeichnet, daß mindestens eine, an dem über dem Meßgebiet liegenden Hautbezirk optische Markierungen bildende Markiereinrichtung (15; 45) vorgesehen ist, die mit einem Positionsgeber (20, 21; 34, 35, 35a) aufweisenden Manipulator (31) versehen oder an einem solchen Manipulator angeordnet ist, wobei diese Positionsgeber zur Abbildung der jeweils vorliegenden Stellung der Markiereinrichtung an der Abbildungseinheit (6) des Kernspintomographen (1) mit dieser Abbildungseinheit (6) oder mit Einstellern (22; 36) in der Steuer- und Recheneinheit (3) des Kernspintomographen (1), die ihrerseits mit der Abbildungseinheit (6) gekoppelt sind, verbunden sind.

7. Apparat nach Anspruch 6, dadurch gekennzeichnet, daß die Markiereinrichtung ein Lichtzeiger ist.

8. Apparat nach Anspruch 7, dadurch gekennzeichnet, daß der Lichtzeiger ein Laserzeiger (15) ist.

9. Apparat nach Anspruch 6, dadurch gekennzeichnet, daß die Markiereinrichtung eine Farbauftragseinrichtung, vorzugsweise eine Farbpunktauftragseinrichtung (45) ist.

**Claims**

1. Apparatus for determining the location of receptor regions with a device which detects the physical properties of the tissue (8) in the area of the receptor regions (7) by means of measurement technology, characterized by the fact that the device which detects the physical properties of the tissue is a nuclear resonance tomograph (1), and that the apparatus furthermore has an indicator device (15; 45; 11, 31, 6) for the skin sites (48) located directly above the receptor regions (7), in the form of a marking device (15; 45) connected with the imaging unit (6) of the nuclear resonance tomograph (1), with which a mark (26) can be placed on the skin site (48) located above the measurement area, or in the form of at least one indicator element (11) which can be placed on the skin and being arranged at a manipulator (31) provided with positioning elements (34, 35, 35a).

2. Apparatus pursuant to claim 1, characterized by the fact that the nuclear resonance tomograph (1) is structured to detect the distribution of hydrogen atoms respectively protons in the tissue.

3. Apparatus pursuant to claim 1 or 2, characterized by the fact that the nuclear resonance tomograph (1) is a low field nuclear resonance tomograph.

4. Apparatus pursuant to one of claims 1 to 3, characterized by the fact that at least the receiver coil (5) of the nuclear resonance tomograph (1), or a transmitter and receiver coil of the same, and, if necessary, also a transmitter coil (5) of the nuclear resonance tomograph, is/are structured as movable elements, which can be placed directly on the measurement area, e.g. on the ear or on a location of the torso.

5. Apparatus pursuant to one of claims 1 to 4, characterized by the fact that the positioning elements (34, 35, 35a) of the manipulator (31) at which the indicator element (11) is arranged are connected with the imaging unit (6) of the nuclear resonance tomograph or with adjusters (36) in the control and computer unit (3) of the nuclear resonance tomograph (1), which in turn are coupled with the imaging unit (6), to image on the imaging unit (6) the real-time location of the indicator element (11).

6. Apparatus pursuant to one of claims 1 to 4, characterized by the fact that at least one marking device (15; 45) which forms optical markings on the skin area located above the measurement area is provided, which is arranged at a manipulator (31) provided with position indicating elements (20, 21; 34, 35, 35a), where these position indicating elements are connected to image the real-time location of the marking device on the imaging unit (6) of the nuclear resonance tomograph (1) with this imaging unit (6) or with adjusters (22; 36) in the control and computer unit (3) of the nuclear resonance tomograph (1), which in turn are coupled with the imaging unit (6).

7. Apparatus pursuant to claim 6, characterized by the fact that the marking device is a light pointer.

8. Apparatus pursuant to claim 7, characterized by the fact that the light marker is a laser pointer (15).

9. Apparatus pursuant to claim 6, characterized by the fact that the marking device is a dye application device, preferably a dye dot application device (45).

## Revendications

1. Appareil destiné à déterminer la position de régions de récepteurs (7) au moyen d'un dispositif déterminant, par des techniques de mesure, des propriétés physiques des tissus (8) dans la zone des régions de récepteurs, caractérisé en ce que le dispositif déterminant les propriétés physiques des tissus, est un appareil d'électroradiologie par résonance magnétique nucléaire (1), et en ce que l'appareil comporte en outre un dispositif d'indication (15; 45; 11, 31, 6) pour les régions de peau (48) directement situées au-dessus des régions de récepteurs (7), et se présentant sous la forme d'un dispositif de marquage (15; 45) qui est relié à l'unité de visualisation (6) de l'appareil d'électroradiologie par résonance magnétique nucléaire (1), et à l'aide duquel une marque (26) peut être appliquée sur une région de peau (48) située au-dessus de la zone de mesure, ou bien sous la forme d'au moins un corps indicateur (11) disposé sur un manipulateur (31) muni de capteurs de position (34, 35, 35a).

2. Appareil selon la revendication 1, caractérisé en ce que l'appareil d'électroradiologie par résonance magnétique nucléaire (1) est conçu pour la détection de la répartition d'atomes ou de protons d'hydrogène dans les tissus.

3. Appareil selon la revendication 1 ou 2, caractérisé en ce que l'appareil d'électroradiologie par résonance magnétique nucléaire (1) est un appareil d'électroradiologie par résonance magnétique nucléaire à faible champ.

4. Appareil selon l'une des revendications 1 à 3, caractérisé en ce qu'au moins la bobine de réception (5) de l'appareil d'électroradiologie par résonance magnétique nucléaire (1), ou une bobine d'émission et de réception de cet appareil, et le cas échéant également une bobine d'émission (4) de l'appareil d'électroradiologie par résonance magnétique nucléaire, est ou sont réalisées en tant qu'éléments mobiles, qui peuvent être placés directement au niveau de la zone de mesure, par exemple l'oreille ou une région du tronc.

5. Appareil selon l'une des revendications 1 à 4, caractérisé en ce que les capteurs de position (34, 35, 35a) du manipulateur (31) sur lequel est disposé le corps indicateur (11), en vue de visualiser la position présente du corps indicateur (11) sur l'unité de visualisation (6) de l'appareil d'électroradiologie par résonance magnétique nucléaire (1), sont reliés à cette unité de visualisation (6), ou à des éléments de réglage (36), dans l'unité de commande et de calcul (3) de l'appareil d'électroradiologie par résonance magnétique nucléaire (1), qui pour leur part sont couplés à l'unité de visualisation (6).

6. Appareil selon l'une des revendications 1 à 4, caractérisé en ce qu'il est prévu au moins un dispositif de marquage (15; 45) qui réalise des marques optiques sur la région de peau située au-dessus de la zone de mesure, et qui est pourvu d'un manipulateur (31) équipé de capteurs de position (20, 21; 34, 35, 35a), ou est disposé sur un tel manipulateur, ces capteurs de position, en vue de visualiser la position présente du dispositif de marquage sur l'unité de visualisation (6) de l'appareil d'électroradiologie par résonance magnétique nucléaire (1), étant reliés à cette unité de visualisation (6), ou à des éléments de réglage (22; 36), dans l'unité de commande et de calcul (3) de l'appareil d'électroradiologie par résonance magnétique nucléaire (1), qui pour leur part sont couplés à l'unité de visuaolisation (6).

7. Appareil selon la revendication 6, caractérisé en ce que la dispositif de marquage est un indicateur lumineux.

8. Appareil selon la revendication 7, caractérisé en ce que l'indicateur lumineux est un indicateur laser (15).

9. Appareil selon la revendication 6, caractérisé en ce que le dispositif de marquage est un dispositif d'application de couleur, de préférence un dispositif d'application de points de couleurs (45).

FIG.1

FIG.2

FIG.3

FIG.4

FIG.5